# EUROPEAN PATENT APPLICATION

(11) **EP 1 583 158 A1**
(43) Date of publication of application: **05.10.2005**
(21) Application number: 04007603.6
(22) Date of filing: 29.03.2004
(51) Int. Cl.: H01L 33/00, G02B 3/06

(54) **Light collector for an LED array**

(71) Applicant: Aiptek International Inc., Taiwan (TW)
(72) Inventor: Shih-Yuan, Chang, Datong District Taipei City 103 (TW)
(74) Representative: Winkler, Andreas Fritz Ernst

(57) **Abstract**

A light collector (40) for an LED array (700) is provided. The light collector includes a transparent main body having a first portion and a second portion opposite to each other. The first portion has at least one first semi-cylinder (42) and the second portion has a plurality of second semi-cylindrers (441,442,443), and the first semi-cylinders are perpendicular to the second semi-cylinders. The number and the respective geometric arrangement of the first semi-cylinders and the second semi-cylinders are determined according to the LED array (700). The whole configuration of the light collector can be optimized in order that a desired illuminating area can be produced when the light of the LED array passes through the light collector.

## Description

### BACKGROUND OF THE INVENTION

### 1. Field of the Invention

The present invention relates to a light collector for producing a desired illuminating area, and more particularly to a light collector for an LED array to be adapted in a flash device used for an image-capturing apparatus.

### 2. Description of the Prior Art

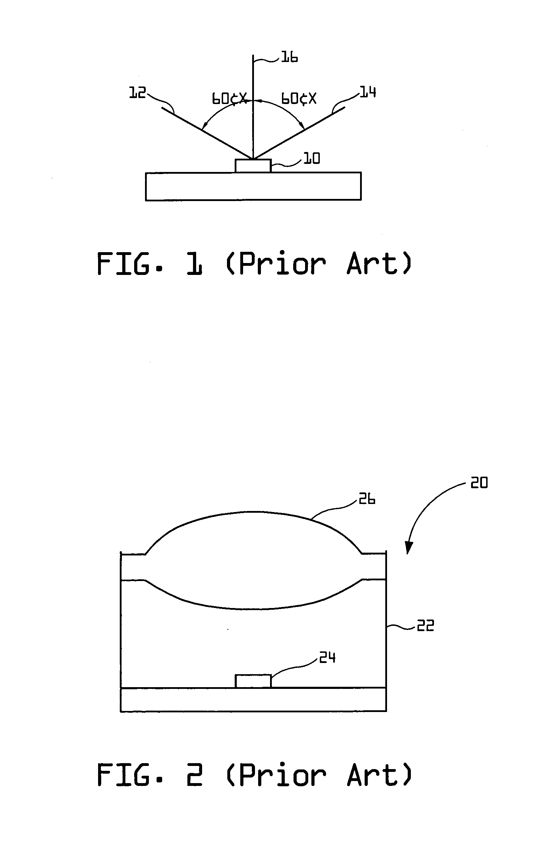

As a good light source and device made by semiconductor material, LEDs possess advantages of small size, high brightness, long life-time, low driving voltage and rapid response, etc. The LEDs have been widely used in small-sized illuminating apparatuses. As shown in FIG. 1, the light emitted from a LED (light emitting diode) 10 is spread over a large area. The behavior of the LED 10 is like a lambertion source. The light is emitted at a broad angle with the half power point 12, 14 being 60 degrees from the vertical axis 16 at a 50-percentage brightness. Thus, most of the light produced by the LED 10 is wasted. Consequently, the electronic devices, such as camera and handset, which require a light source with highly illuminating directionality, typically employ a collection lens to collect and focus the light of the LED 10 onto a target surface.

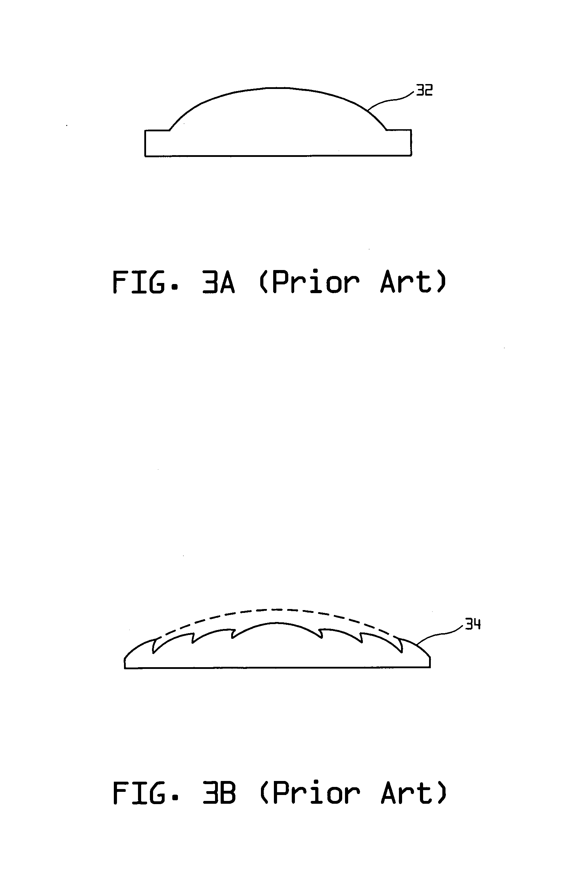

FIG. 2 is a schematic cross-sectional view of a conventional flash unit 20 used in a camera. The flash unit 20 is provided in order to illuminate an object to be photographed. The flash unit 20 is mainly used to take a picture of an object in dim light as well as to remove the unwanted shadow of the object to be photographed in daylight conditions. The flash unit 20 includes a housing 22 having an opening, at least a LED device 24 and a convexo-convex lens 26. The housing 22 encloses the LED device 24 and the convexo-convex lens 26. The convexo-convex lens 26 is positioned in the opening of the housing 22 and in front of the LED device 24 to collect and focus the light of the LED device 24 onto the target surface. As shown in FIGs. 3A and 3B, a convexo-plane lens 32 or a fresnel lens 34 can be used in the flash unit 20 instead of the convexo-convex lens 26. However, the thickness of the convexo-convex lens 26 and convexo-plane lens 32 is large, hence they occupy a larger space. Moreover, the focus lengths of each of them in X and Y directions are equal, and thus producing a circular illuminating area when the light passing through. The circular illuminating area is quite different from a rectangular image-capturing area of the camera that generally has a ratio of 4:3 in X and Y dimensions. As a consequence, portion of the light is wasted, and the utilization of the light produced by the LED device 24 is decreased. Although the thickness of the fresnel lens 34 is thinner than the convexo-convex lens 26 and convexo-plane lens 32, the utilization of the light produced by the LED device 24 is subjected to by the configuration of the fresnel lens 34.

Therefore, there is a need in the art for a LED light collection system that is efficient and compact.

### SUMMARY OF THE INVENTION

It is one objective of the present invention to provide a light collector for an LED (light emitting diode) array, whose whole configuration is optimized to produce a desired illuminating area.

It is another objective of the present invention to provide a light collector for a light source of a flash device used in a camera, the whole configuration of the light collector is optimized to produce a desired illuminating area matched with an image-capturing area of the camera. As a consequence, the utilization of the light source is improved.

In order to achieve the above objectives of this invention, the present invention provides a light collector for an LED array. The light collector includes a transparent main body having a first portion and a second portion opposite to each other. The first portion has at least one first semi-cylinder, and the second portion has a plurality of second semi-cylinders. The first semi-cylinders are perpendicular to the second semi-cylinders. The number and the respective geometric arrangement of the first semi-cylinder and second semi-cylinder is determined according to the LED array in order that the whole configuration of the light collector can be optimized to produce a desired illuminating area on a target surface.

In a first embodiment of the present invention, the light collector has the first portion having a first semi-cylinder and the second portion having a plurality of second semi-cylinders arranged in a linear array. In a second embodiment of the present invention, the light collector has the first portion having a pair of first semi-cylinders parallely arranged together and the second portion having at least three second semi-cylinders arranged in a triangular geometry. In a third embodiment of the present invention, the first portion of the light collector has a pair of first semi-cylinders parallely arranged together and the second portion has a plurality of second semi-cylinders arranged in a two-dimensional array.

The light collector can be produced by mold injection, and the mold for forming the light collector can be simplified. By the way, the accuracy of the light collector can be properly controlled.

### BRIEF DESCRIPTION OF THE DRAWINGS

The objectives and features of the present invention as well as advantages thereof will become apparent from the following detailed description, considered in conjunction with the accompanying drawings.
FIG. 1 depicts light emission from a standard LED;
FIG. 2 is a schematic cross-sectional view of a conventional flash device;
FIG. 3A is a schematic cross-sectional view of a convexo-convex lens;
FIG. 3B is a schematic cross-sectional view of a fresnel lens;
FIG. 4A is a schematic top view of a light collector of the present invention according to a first embodiment;
FIG. 4B is a schematic bottom view of the light collector of FIG. 4A;
FIG. 4C is a schematic cross-sectional view of the light collector along the transverse line A₁-A₂ of FIG. 4A;
FIG. 4D is a schematic cross-sectional view of the light collector along the longitudinal line B₁-B₂ of FIG. 4B;
FIG. 5A is a schematic top view of a light collector of the present invention according to a second embodiment;
FIG. 5B is a schematic bottom view of the light collector of FIG. 5A;
FIG. 6A is a schematic top view of a light collector of the present invention according to a third embodiment;
FIG. 6B is a schematic bottom view of the light collector of FIG. 6A;
FIG. 7A is a schematic bottom view of an illuminating device, which employs the light collector of FIG. 4A;
FIG. 7B is a schematic bottom view of an illuminating device, which employs the light collector of FIG. 5A;
FIG. 7C is a schematic bottom view of an illuminating device, which employs the light collector of FIG. 6A; and
FIG. 8 is a schematic cross-sectional view of a flash device of the present invention.

### DESCRIPTION OF THE EMBODIMENTS

The present invention provides a light collector for an LED array, which is used to produce a desired illuminating area when the light of the LED array passing through so as to match a target surface. Hence, the utilization of the light of the LED array can be improved. The light collector includes a transparent main body having a first portion and a second portion opposite to each other. The first portion has at least one first semi-cylinder and the second portion has a plurality of second semi-cylinders. The longitudinal axis of the first semi-cylinders is perpendicular to the longitudinal axis of each of the second semi-cylinders. The number and the respective geometric arrangement of the first semi-cylinders and the second semi-cylinders are determined according to the LED array. Therefore, the whole configuration of the light collector can be optimized to produce the desired illuminating area when the light of the LED array passing through. Hence, the purpose for improving the utilization of the light of the LED array can be attained. Moreover, the thickness of the first semi-cylinder and second semi-cylinder of the main body of the light collector is thinner than that of the conventional spherical lens. The light collector of the present invention would occupy a smaller volume.

The present invention will be described in detail in accordance with the following embodiments with reference to accompanying drawings.

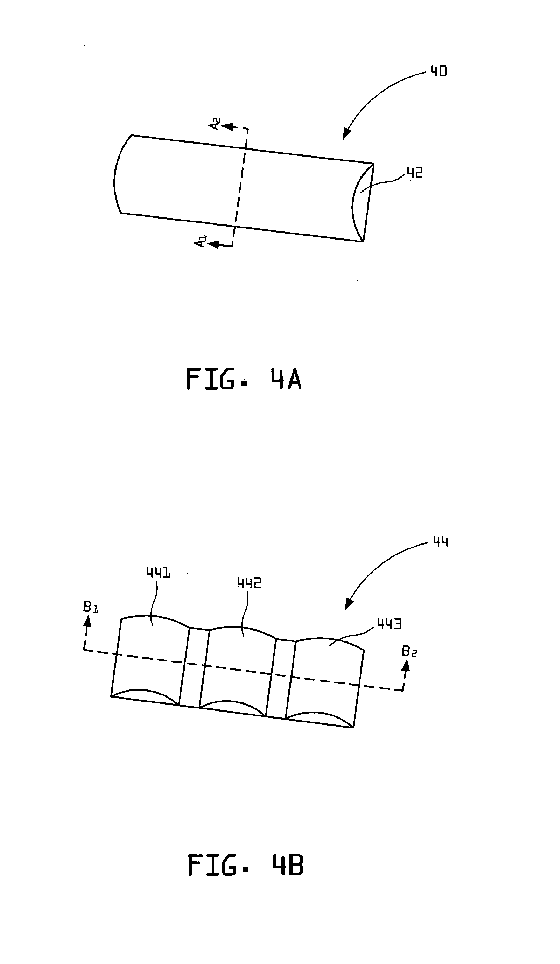

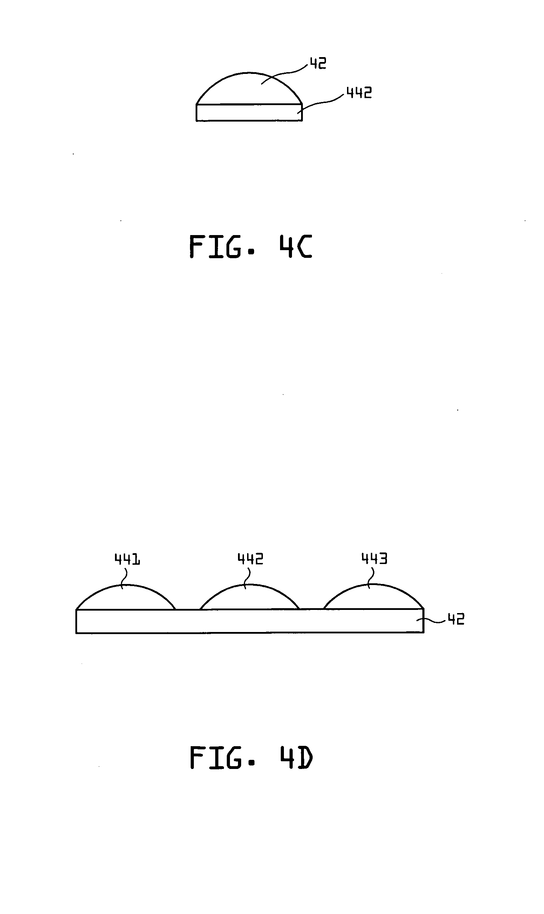

FIGs. 4A to 4D are various schematic views of a light collector 40 of the present invention according to a first embodiment. FIG. 4A is a schematic top view of the light collector 40; FIG. 4B is a schematic bottom view of the light collector 40; FIG. 4C is a schematic cross-sectional view of the light collector 40 along the traverse line A₁-A₂ of FIG. 4A; FIG. 4D is a schematic cross-sectional view of the light collector 40 along the longitudinal line B₁-B₂ of FIG. 4B. The light collector 40 includes a transparent main body having a first portion 42 and a second portion 44. The first portion 42 is formed of one first semi-cylinder and the second portion 44 is formed of three second semi-cylinders 441, 442 and 443 arranged in a linear array. The longitudinal axis of the first semi-cylinder is perpendicular to the longitudinal axis of each of the three second semi-cylinders 441, 442 and 443. The curvature of the first semi-cylinder can be spherical curvature or non-spherical curvature. The curvature of the second semi-cylinders 441, 442 and 443 can be spherical curvature or non-spherical curvature. The curvatures of the first semi-cylinder 42 and the second semi-cylinders 441, 442 and 443 depend on the desired whole configuration of the transparent main body of the light collector 40.

The transparent main body of the light collector 40 of the present invention can be integrally formed by mold injection. The material of the transparent main body can be glass, polymethyl methylacrylate (PMMA), polycarbonate, acrylic resin, epoxy, urethane, styrene, and the like.

FIG. 7A is a schematic bottom view of an illuminating device 70, which employs the light collector 40. The illuminating device 70 includes an LED array 700 and the light collector 40. The LED array 700 includes a plurality of light emitting diodes 441, 442 and 443. The light collector 40 is positioned in front of the LED array 700. The second portion 44 of the light collector 40 faces to the LED array 700. The light emitting diodes 701, 702 and 703 are respectively positioned under a central part of one of the second semi-cylinders 441,442 and 443. That is to say, the light emitting diodes 701, 702 and 703 of the LED array 700 correspond to the second semi-cylinders 441,442 and 443 in a one-to-one basis. The second semi-cylinders 441, 442 and 443 of the light collector 40 face to the LED array 700 and the first semi-cylinder 42 is distanced away the LED array 700. As a consequence, the emission range of the light of the LED array 700 in Y direction is converged through the second semi-cylinders 441, 442 and 443, the emission range of the light of the LED array 700 in X direction is converged through the first semi-cylinder 42. When the light of the LED array 700 passes through the light collector 40, an approximate rectangular illuminating area produced by the light collector 40 is projected onto a target surface.

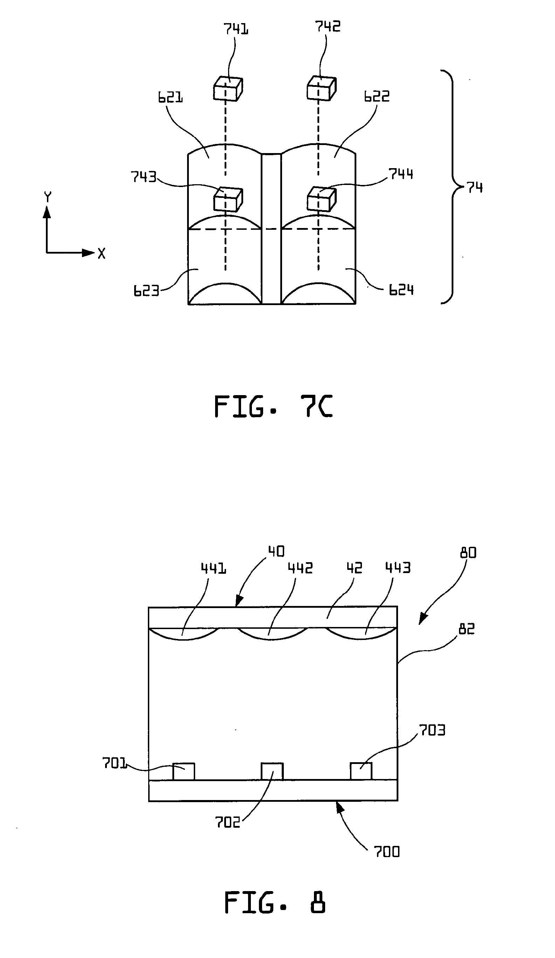

FIG. 8 is a schematic cross-sectional view of a flash device 80, which employs the illuminating device 70 of FIG. 7A. The flash device 80 includes a housing 82 having an opening, the LED array 700 and the light collector 40. The LED array 700 is positioned in the housing 82. The light collector 40 is positioned in front of the LED array 40 within the opening of the housing 82. When the flash device 80 is used in a camera, the flash device 80 provides the approximate rectangular illuminating area unto an object to take a picture. In general, the image-capturing area of the camera is a rectangular area with a ratio about 4:3 for the X dimension to the Y dimension. Therefore, the approximate rectangular illuminating area can match with the image-capturing area of the camera. The light of the LED array 700 would not be wasted, and the utilization of the LED array 700 is improved.

Referring to FIGs. 4A and 4B again, the light collector 40 has a first portion 42 having one first semi-cylinder and a second portion 44 having three second semi-cylinders 441, 442 and 443 arranged in a linear array. However, the second portion 44 of the light collector 40 can be provided with a plurality of second semi-cylinders arranged in a linear array instead of the three second semi-cylinders 441, 442 and 443. Thus, the light collector can associate with an LED array including a plurality of light emitting diodes to form an illuminating device, each of the light emitting diodes corresponding to one of the second semi-cylinders in a one-to-one basis.

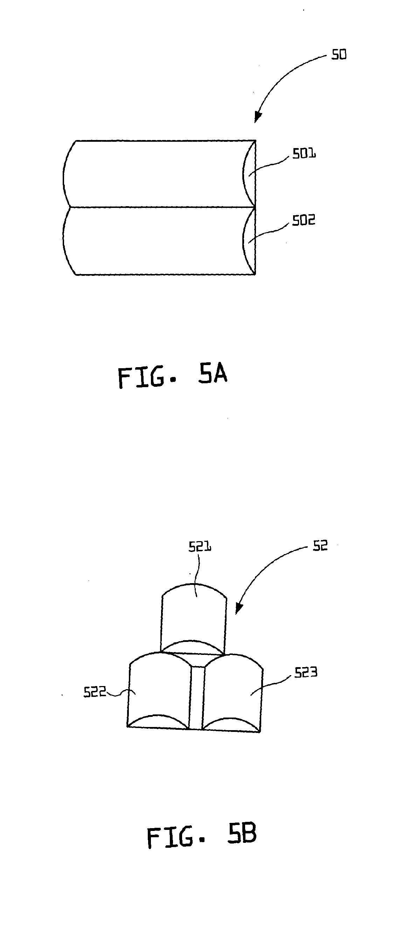

FIGs. 5A to 5B are various schematic views of a light collector of the present invention according to a second embodiment. FIG. 5A is a schematic top view of the light collector; FIG. 5B is a schematic bottom view of the light collector. The light collector of the second embodiment includes a transparent main body having a first portion 50 and a second portion 52. The first portion 50 is formed of a pair of first semi-cylinders 501 and 502 parallely arranged together, and the second portion 52 is formed of three second semi-cylinders 521, 522 and 523 arranged in a triangular geometry. The longitudinal axis of the first semi-cylinders 501 and 502 is perpendicular to the longitudinal axis of each of the three second semi-cylinders 521, 522 and 523. The curvature of the first semi-cylinders 501 and 502 can be spherical curvature or non-spherical curvature. The curvature of the second semi-cylinders 521, 522 and 523 can be spherical curvature or non-spherical curvature. The curvatures of the first semi-cylinders 501 and 502 and the second semi-cylinders 521, 522 and 523 depend on the desired whole configuration of the transparent main body of the light collector of the second embodiment.

The transparent main body of the light collector of the second embodiment can be integrally formed by mold injection. The material of the transparent main body can be glass, polymethyl methylacrylate (PMMA), polycarbonate, acrylic resin, epoxy, urethane, styrene, and the like.

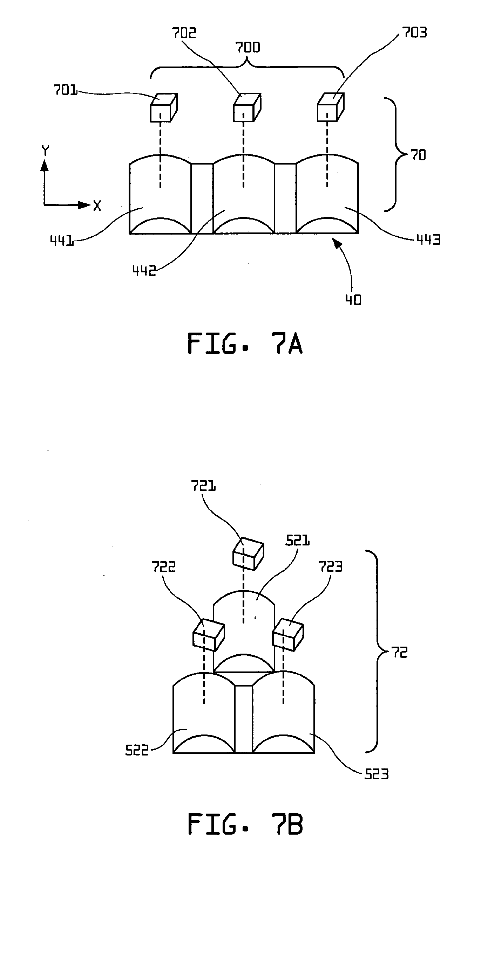

FIG. 7B is a schematic bottom view of an illuminating device 72, which employs the light collector of the second embodiment of FIGs. 5A and 5B. The illuminating device 72 includes an LED array including three light emitting diodes 721, 722 and 723 arranged in a triangular geometry. The light collector is positioned in front of the LED array, and the second portion 52 of the light collector faces to the LED array. The light emitting diodes 721, 722 and 723 are respectively positioned under a central part of one of the second semi-cylinders 721, 722 and 723. That is to say, the light emitting diodes 721, 722 and 723 of the LED array correspond to the second semi-cylinders 521, 522 and 523 in a one-to-one basis.

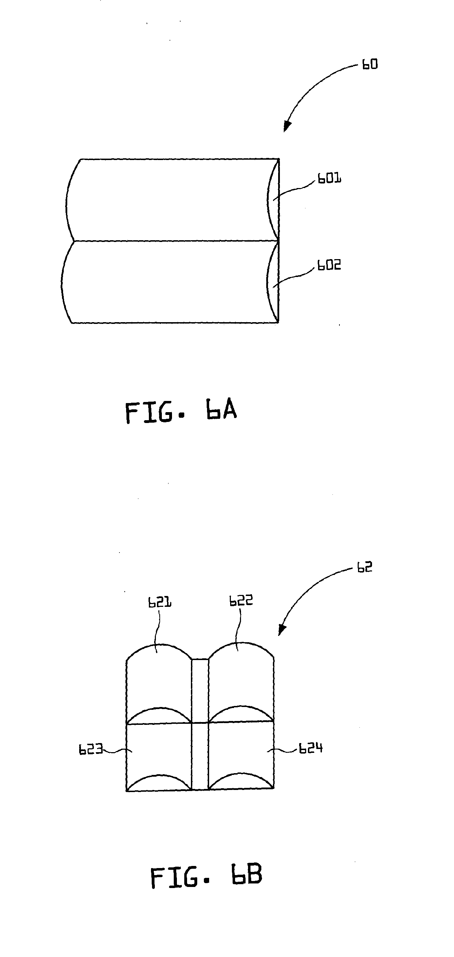

FIGs. 6A to 6B are various schematic views of a light collector of the present invention according to a third embodiment. FIG. 6A is a schematic top view of the light collector; FIG. 6B is a schematic bottom view of the light collector. The light collector of the third embodiment includes a transparent main body having a first portion 60 and a second portion 62. The first portion 60 is formed of a pair of first semi-cylinders 601 and 602 parallely arranged together. The second portion 62 is formed of four second semi-cylinders 621, 622, 623 and 624 arranged in a two-dimensional array. The longitudinal axis of the first semi-cylinders 601 and 602 is perpendicular to the longitudinal axis of each of the four second semi-cylinders 621, 622, 623 and 624. The curvature of the first semi-cylinders 601 and 602 can be spherical curvature or non-spherical curvature. The curvature of the second semi-cylinders 621, 622, 623 and 624 can be spherical curvature or non-spherical curvature. The curvatures of the first semi-cylinders 601 and 602 and the second semi-cylinders 621, 622, 623 and 624 depend on the desired whole configuration of the transparent main body of the light collector of the third embodiment.

The transparent main body of the light collector of the third embodiment can be integrally formed by mold injection. The material of the transparent main body can be glass, polymethyl methylacrylate (PMMA), polycarbonate, acrylic resin, epoxy, urethane, styrene, and the like.

FIG. 7C is a schematic bottom view of an illuminating device 74, which employs the light collector of the third embodiment of FIGs. 6A and 6B. The illuminating device 74 includes an LED array including four light emitting diodes 741, 742, 743 and 744 arranged in a two-dimensional array. The light collector is positioned in front of the LED array, and the second portion 62 of the light collector faces to the LED array. The light emitting diodes 741, 742, 743 and 744 are respectively positioned under a central part of one of the second semi-cylinders 621, 622, 623 and 624. That is to say, the light emitting diodes 741, 742, 743 and 744 of the LED array correspond to the second semi-cylinders 621, 622, 623 and 624 in a one-to-one basis. The second semi-cylinders 621, 622, 623 and 624 of the light collector face to the LED array and the first semi-cylinders 601 and 602 are distanced away the LED array. As a consequence, the emission range of the light of the LED array in Y direction is converged through the second semi-cylinders 621, 622, 623 and 624, the emission range of the light of the LED array in X direction is converged through the first semi-cylinders 601 and 602. When the light of the LED array passes through the light collector, an approximate square illuminating area can be produced through the light collector.

Referring to FIGs. 6A and 6B again, the light collector has a first portion 60 having a pair of first semi-cylinders 601 and 602 and a second portion 62 having four second semi-cylinders 621, 622, 623 and 624 arranged in a two-dimensional array. However, the second portion 62 of the light collector can be provided with a plurality of second semi-cylinders arranged in a two-dimensional array instead of the four second semi-cylinders 621, 622, 623 and 624. Thus, the light collector can associate with an LED array including a plurality of light emitting diodes to form an illuminating device, each of the light emitting diodes corresponding to one of the second semi-cylinders in a one-to-one basis.

The number, the curvature and the respective geometric arrangement of the first semi-cylinders and the second semi-cylinders of the light collector of the present invention can be determined according to the LED array to be combined. Therefore, the whole configuration of the light collector of the present invention can be optimized to produce a desired illuminating area when the light of the LED array passing through the light collector. Thus, the utilization of the light of the LED array can be improved.

The embodiments are only used to illustrate the present invention, not intended to limit the scope thereof. Many modifications of the embodiments can be made without departing from the spirit of the present invention.

## Claims

1. A light collector for an LED array, comprising a transparent main body having a first portion and a second portion opposite to each other, said first portion having at least one first semi-cylinder and said second portion having a plurality of second semi-cylinders, said first semi-cylinders being perpendicular to said second semi-cylinders; wherein the number and the respective geometric arrangement of said first semi-cylinders and said second semi-cylinders are determined according to the LED array.

2. The light collector of claim 1, wherein said first portion has one first semi-cylinder and said second portion has a plurality of said second semi-cylinders arranged in a linear array.

3. The light collector of claim 1, wherein said first portion has a pair of first semi-cylinders parallely arranged together and said second portion has a plurality of said second semi-cylinders arranged in a two-dimensional array.

4. The light collector of claim 3, wherein said second portion has four said second semi-cylinders.

5. The light collector of claim 1, wherein said first portion has a pair of said first semi-cylinders parallely arranged together and said second portion has at least three said second semi-cylinders arranged in a triangular geometry.
